# EUROPEAN PATENT APPLICATION

(11) **EP 1 962 264 A1**
(43) Date of publication of application: **27.08.2008**
(21) Application number: 08151593.4
(22) Date of filing: 19.02.2008
(51) Int. Cl.: G09G 3/28

(54) **Reset circuit and plasma display device including the same**

(30) Priority: 23.02.2007 KR 20070018706
(71) Applicant: Samsung SDI Co., Ltd., Suwon-si Gyeonggi-do (KR)
(72) Inventor: Song, Yoo-Jin, Gyeonggi-do (KR)
(74) Representative: Hengelhaupt, Jürgen

(57) **Abstract**

A reset circuit preventing the malfunction and breakage of an integrated circuit included in a plasma display device, and a plasma display device including the same, wherein the reset circuit monitors the input voltage applied to the integrated circuits of the plasma display device to control the reset or non-reset operation of the integrated circuits.

## Description

### BACKGROUND

### 1. Field of the Invention

The present invention relates to a plasma display panel (PDP) device, and more particularly to a PDP device including a reset circuit in an integrated circuit (IC).

### 2. Discussion of Related Art

Recently, flat panel displays such as liquid crystal displays (LCDs), field emission displays (FEDs), and plasma display panels (PDPs), etc. have actively been developed. The PDP among the flat panel displays has the advantage of higher brightness and luminous efficiency and wider viewing angle than other flat panel displays. Accordingly, the PDP has been put in the spotlight as a display technology to replace a conventional cathode ray tube (CRT) in a large display exceeding 40 inches.

The PDP is a flat panel display for displaying letters or images using plasma generated by gas discharge, wherein several hundreds of thousands to millions of pixels are arranged on the PDP in a matrix form depending on its size. The PDP is classified into a direct-current (DC) type PDP and an alternating-current (AC) type PDP according to a driving voltage waveform applied and a structure of the discharge cells.

The DC type PDP allows current to flow to a discharge space during the application of voltages since the electrodes are exposed without insulation in the discharge space. As a result, it is disadvantageous in that the DC type PDP should be provided with a resistor for limiting current. Meanwhile, the AC type PDP has the advantage of having the electrodes covered with a dielectric layer, so that a capacitance component is formed naturally therein to limit current and the electrodes are protected from the impact of ions when discharging. Thus, the electrodes of the AC type PDP have a longer lifetime than that of the DC type PDP.

One surface of the AC type PDP is formed with scan electrodes and sustain electrodes parallel to each other, and the other surface thereof is formed with address electrodes in a direction orthogonal to the scan and sustain electrodes. The sustain electrodes are formed corresponding to the scan electrodes, wherein the sustain electrodes are coupled in common at one terminal.

In general, a driving method of the AC type PDP includes a reset period, an addressing period, a sustain period, and an erase period over a display driving time interval.

The reset period is a period for initializing the state of each cell in order to smoothly perform addressing operations of the cells, and the addressing period is a period for performing operations to accumulate wall charges by applying an address voltage to turned-on cells (addressed cells) in order to select turned-on cells and turned-off cells on the panel. The sustain period is a period for performing discharge for actually displaying images on the addressed cells by applying sustain discharge voltage pulses, and the erase period is a period for terminating the sustain discharge by reducing the wall charges in the cells.

Also, the PDP is provided with ICs in order to apply predetermined voltages to the scan electrodes, the sustain electrodes, and the address electrodes. As the prices of PDPs are falling, the ICs included in the PDPs continue to have an increased number of channels.

The ICs receive an operation power and an input signal to provide predetermined output voltages to the scan electrodes, the sustain electrodes, and the address electrodes. In the conventional case, when the voltage of the operation power in a floating state that is input to the ICs is suddenly changed, or the level of the input signal fluctuates, there is a risk of malfunction of the ICs.

Nevertheless, in the conventional case, since an output signal of the IC is controlled by using an existing CLR signal or a latch enable signal, when the unexpected fluctuations of the input signal or the operation power occur, the IC cannot control them, so that it is disadvantageous in that the circuits inside the IC receive the fluctuating input signal or operation power.

As an example, when the IC is input with a voltage level of the floating operation power lower than a reference value, the signal level applied to the IC is equally lowered. When the voltage levels of the operation power and input signal drop to a particular voltage or less, the control operation inside the IC becomes unstable, causing the switches inside the IC to malfunction. Furthermore, the malfunction of the switches can lead to the malfunction and breakage of the IC itself.

### SUMMARY OF THE INVENTION

In one embodiment of the present invention, there is provided a reset circuit for a plasma display device, wherein the reset circuit is adapted to sense an input voltage and to output a control signal.

In another embodiment of the present invention, a reset circuit prevents or reduces the malfunction and breakage of an IC included in a plasma display device, and the plasma display device including the same, wherein the reset circuit monitors an input voltage applied to the IC of the plasma display device to control the reset or non-reset operation of the IC.

In yet another embodiment of the present invention, there is provided a plasma display device, including: a plasma device panel including a plurality of address electrodes extending in a column direction, and scan electrodes and sustain electrodes extending in a row direction; an address electrode driver for applying display data signals to the address electrodes in order to select discharge cells to be displayed on the plasma display panel; a sustain electrode driver and a scan electrode driver applying driving voltages to the sustain electrodes and the scan electrodes, respectively; a controller for receiving an image signal from an external source and outputting an address electrode driving control signal, a sustain electrode driving control signal, and a scan electrode driving control signal; a power supply unit for providing an input voltage to the address electrode driver, the scan electrode driver, and the sustain electrode driver; and a reset circuit for sensing the input voltage to output a reset control signal to control a reset or non-reset of the address electrode driver, the scan electrode driver, and the sustain electrode driver.

In still another embodiment, there is provided a reset circuit of a plasma display device for controlling reset operations of respective drivers of a plurality of address electrodes, a plurality of scan electrodes, and a plurality of sustain electrodes. The address electrodes extend in a column direction, and the scan electrodes and sustain electrodes extend in a row direction. The reset circuit includes a comparator including first and second input terminals, a Zener diode coupled between a first node receiving an input voltage and the second input terminal of the comparator, and a transistor coupled between the first node and the output terminal for receiving an output of the comparator. The first input terminal receives a first terminal voltage which is less than a preset voltage, and the second input terminal receives a second terminal voltage corresponding to the difference Vdd-Vz, wherein Vdd is a voltage level of the input voltage, and Vz is a breakdown voltage of the Zener diode.

In still yet another embodiment, there is provided a method to operate a driver of a plasma display device, wherein the driver receives an input voltage from an outside source. The input voltage as received by the driver is monitored. The input voltage is compared to a threshold voltage. A first control signal is generated to control the driver to be not driven when the input voltage is less than the threshold voltage, and a second control signal is generated to control the driver to be driven when the input voltage is equal to or higher than the threshold voltage, wherein the threshold voltage is suitably selected to cause the driver to be not driven in order to prevent the driver from operating undesirably when the input voltage drops below the threshold voltage. The input voltage may be an input power voltage applied to the driver. The threshold voltage can be generated by using a breakdown voltage of a Zener diode. The input voltage can be compared to the threshold voltage by utilizing a comparator circuit. The input voltage can be voltage-divided before the input voltage is compared to the threshold voltage.

### BRIEF DESCRIPTION OF THE DRAWINGS

These and/or other aspects and features of the invention will become apparent and more readily appreciated from the following description of the exemplary embodiments, taken in conjunction with the accompanying drawings of which:

FIG. 1 is a block diagram showing a plasma display device according to an embodiment of the present invention;

FIG. 2 is a circuit diagram of a reset circuit according to the embodiment of the present invention shown in FIG. 1; and

FIG. 3 is a timing diagram for explaining the operation of the reset circuit shown in FIG. 2.

### DETAILED DESCRIPTION OF THE EMBODIMENTS

Hereinafter, certain exemplary embodiments according to the present invention will be described with reference to the accompanying drawings. Here, when a first element is described as being coupled to a second element, the first element may be not only directly coupled to the second element but may also be indirectly coupled to the second element via a third element. Further, some of the elements that are not essential to the complete understanding of the invention are omitted for clarity. Also, like reference numerals refer to like elements throughout.

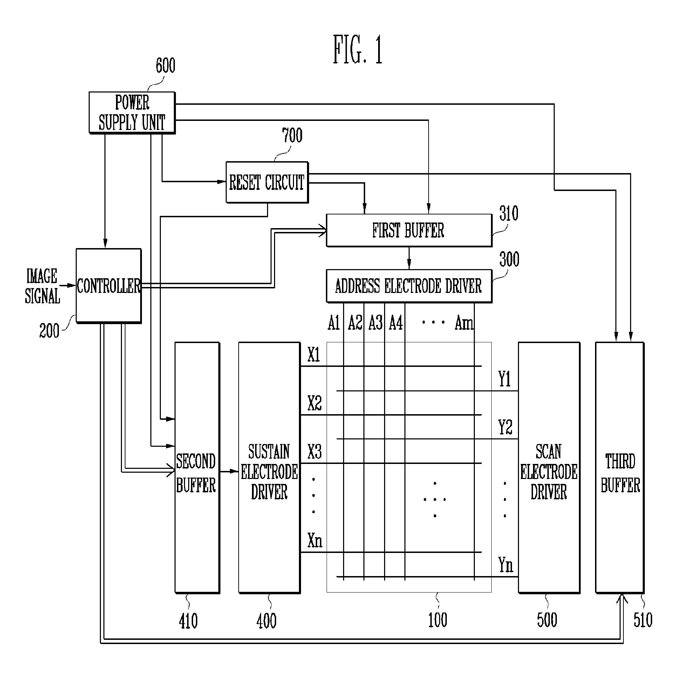

FIG. 1 is a block diagram showing a plasma display device according to an embodiment of the present invention.

As shown in FIG. 1, the plasma display device according to the embodiment of the present invention includes a plasma display panel 100, a controller 200, an address electrode driver 300, a sustain electrode driver 400, a scan electrode driver 500, and a power supply unit 600. The plasma display device also includes a reset circuit 700 for monitoring an input voltage Vdd applied to the address electrode driver 300, the sustain electrode driver 400, and the scan electrode driver 500, each implemented by an integrated circuit (IC) to control a reset or a non-reset operation (e.g., operation or non-operation) of the ICs.

Further, the embodiment includes first, second, and third buffers 310, 410, and 510 for transmitting control signals from the controller 200 and the reset circuit 700 to the address electrode driver 300, the sustain electrode driver 400, and the scan electrode driver 500, respectively.

The plasma display panel 100 includes a plurality of address electrodes A1 to Am extending in a column direction, and a plurality of sustain electrodes X1 to Xn and a plurality of scan electrodes Y1 to Yn extending in a row direction. The sustain electrodes and the scan electrodes are formed in pairs with each other. The sustain electrodes X1 to Xn are formed corresponding to the scan electrodes Y1 to Yn. The sustain electrodes X1 to Xn are connected to each other at one terminal.

The plasma display panel 100 includes a first substrate (not shown) on which the sustain and scan electrodes X 1 to Xn and Y 1 to Yn are arranged and a second substrate (not shown) on which the address electrodes A1 to Am are arranged. The two substrates are disposed to be opposite to each other, creating a discharge space therebetween. The scan electrodes Y1 to Yn are orthogonal to the address electrodes A1 to Am, and the sustain electrodes X1 to Xn are orthogonal to the address electrodes A1 to Am. Furthermore, the discharge spaces at the crossing parts of the address electrodes A1 to Am and the sustain and scan electrodes X1 to Xn and Y1 to Yn form discharge cells. The structure of the plasma display panel 100 is only one exemplary embodiment, and a panel with other structures employing a driving waveform described below can be applied to the present invention.

The controller 200 receives an image signal from an external source and outputs an address electrode driving control signal, a sustain electrode (X) driving control signal, and a scan electrode (Y) driving control signal. The controller 200 is driven by dividing one frame into a plurality of subfields, wherein each subfield includes a reset period, an address period, and a sustain period during an operational time interval.

The address electrode driver 300 receives the address electrode driving control signal and applies a display data signal for selecting the discharge cells to be displayed to each address electrode.

The sustain electrode driver 400 receives the sustain electrode (X) driving control signal from the controller 200 and applies driving voltages to the sustain electrodes (X).

The scan electrode driver 500 receives the scan electrode (Y) driving control signal from the controller 200 and applies driving voltages to the scan electrodes (Y).

The power supply unit 600 supplies power required for driving the plasma display device to the controller 200 and each driver 300, 400, and 500.

The address electrode driver 300, the sustain electrode driver 400, and the scan electrode driver 500 are each implemented by the IC included in the plasma display device.

The ICs receive an input voltage Vdd from the power supply unit 600 and the control signals and input signal from the controller 200 to provide driving voltages (e.g., the voltages can be predetermined) to the scan electrodes, the sustain electrodes, and the address electrodes, respectively.

As described above, in the conventional case, when the input voltage Vdd in a floating state, which is input to the IC, is suddenly changed, or the level of the input signal fluctuates, there is a risk of malfunction of the IC. Nevertheless, since an output signal of the IC is controlled by using a CLR signal or a latch enable signal, when the unexpected fluctuations of the input signal or the input voltage occur, the IC cannot control them. Thus, the IC receives the fluctuating input signal or input voltage Vdd.

The embodiment of the present invention includes the reset circuit 700 in order to overcome the problems described above.

The reset circuit 700 monitors the input voltage Vdd applied to the address electrode driver 300, the sustain electrode driver 400, and the scan electrode driver 500, all of which are implemented by the respective ICs. The reset circuit 700 provides reset signals to the ICs so that they are operated only when the input voltage is applied within a certain voltage range for the normal operations of the ICs.

By way of example, the reset circuit 700 receives the input voltage Vdd which is also applied to the respective ICs from the power supply unit 600. The reset circuit 700 generates a first control signal (disable) to cause the ICs not to be driven during a first period in which the input voltage Vdd is less than a preset voltage as determined by a comparator in the reset circuit 700 and applies the first control signal (disable) to the respective ICs. The reset circuit 700 also generates a second control signal (enable) to cause the ICs to be driven during a second period in which the input voltage Vdd is equal to the preset voltage or more and applies the second control signal (enable) to the respective ICs.

As shown in FIG. 1, the first and second control signals are applied to a first buffer 310, a second buffer 410, and a third buffer 510 coupled to the front ends of the respective ICs. When the first, second, and third buffers are enabled by the second control signal (enable), the address electrode driver 300, the sustain electrode driver 400, and the scan electrode driver 500 are being driven.

As a result, the malfunction caused by the unstable states of the input signal and the input voltage Vdd applied to the ICs and the breakage of the ICs due to the malfunction can be prevented or reduced, making it possible to reduce the error rate of the final product and to enhance the reliability and manufacturing yield of the plasma display device.

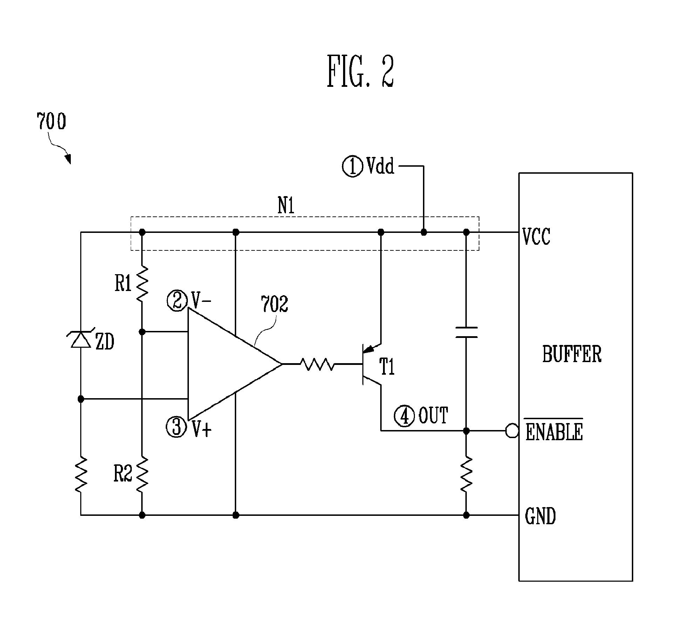

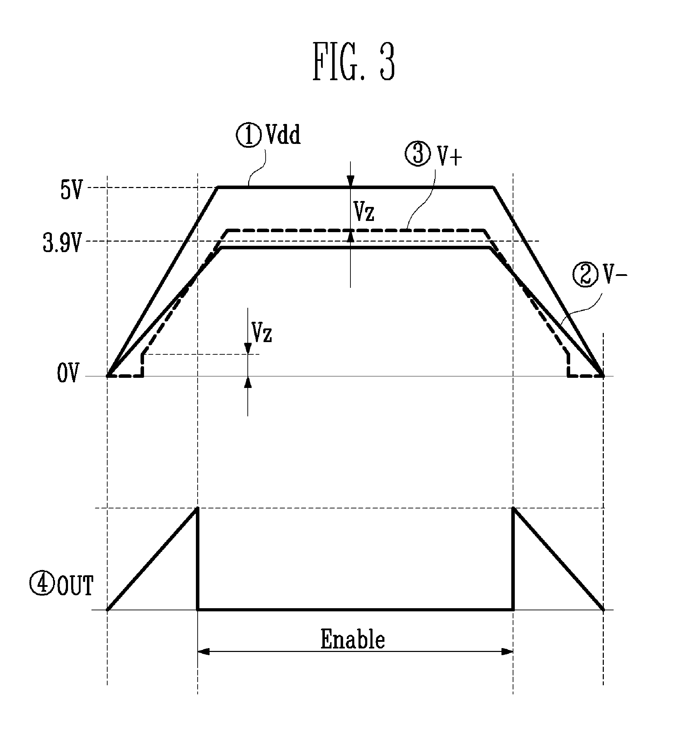

FIG. 2 is a circuit diagram of a reset circuit according to the embodiment of the present invention shown in FIG. 1, and FIG. 3 is a timing diagram explaining the operation of the reset circuit shown in FIG. 2.

Referring to FIG. 2, the reset circuit 700 includes a comparator 702 having first and second input terminals V- and V+; a first resistor R1 coupled between the first input terminal V- of the comparator and a first node N1 receiving the input voltage Vdd; a second resistor R2 coupled between the first input terminal V- of the comparator and a ground GND; a Zener diode ZD coupled between the first node N1 and the second input terminal V+ of the comparator; and a transistor T1 coupled between the first node N1 and an output terminal OUT.

The comparator 702 compares the magnitude of voltage input to the first input terminal V- with the magnitude of voltage input to the second input terminal V+, and outputs a low level signal when the magnitude of voltage input to the first input terminal V- is larger than that of the voltage input to the second input terminal V+ and a high level signal when the magnitude of voltage input to the second input terminal V+ is larger than that of the voltage input to the first input terminal V-. In other words, the first input terminal V- is an inverted (-) input terminal, and the second input terminal is a non-inverted (+) input terminal.

In one embodiment of the present invention, the voltage input to the first input terminal V- is less than or equal to the input voltage Vdd by a certain value (e.g., this value can be predetermined). The voltage input to the second input terminal V+ differs from the input voltage Vdd by a breakdown voltage Vz of the Zener diode. Thus, the difference Vdd-Vz of the input voltage Vdd and the breakdown voltage Vz determines the input voltage level to the second input terminal V+.

Also, the transistor T1 performs a function of a switch. Although the embodiment of the present invention describes a PNP type bipolar transistor (BJT) as one example, this is only one embodiment and the present invention is not limited thereto.

As a result, the base of the transistor T1 receives the output signal of the comparator, and the transistor T1 is turned on/off according to the voltage level of the output signal of the comparator 702. If the transistor T 1 is turned on, an emitter of the transistor coupled to the first node N1 and a collector of the transistor T1 coupled to the output terminal OUT are electrically conducting to allow a current to flow.

Also, the first node N1 receives the input voltage Vdd from the power supply unit 600.

Accordingly, in the embodiment shown in FIG. 2, the first input terminal V- of the comparator receives a voltage corresponding to (R2/(R1+R2))*Vdd generated by voltage-dividing the input voltage Vdd by the first resistor R1 and the second resistor R2, and the second input terminal V+ receives the voltage corresponding to Vdd-Vz when the input voltage Vdd is supplied at a magnitude over the breakdown voltage Vz of the Zener diode.

When each of the first input terminal V- and the second input terminal V+ of the comparator is supplied with the respective voltage inputs, the comparator compares the magnitudes of the voltage inputs to the first and second input terminals and outputs a low level signal or a high level signal.

When the output of the comparator is a low level signal, the low level signal is coupled to the base of the transistor T 1 so that the transistor is turned on to output the input voltage Vdd applied to the first node N1 coupled to the emitter of the transistor T 1 to the output terminal OUT coupled to the collector of the transistor T 1.

On the other hand, when the output of the comparator is a high level signal, the high level signal is input to the base of the transistor T 1 so that the transistor T 1 is turned off to output a low level voltage corresponding to a ground voltage to the output terminal OUT coupled to the collector of the transistor T 1.

The embodiment of the present invention uses the low level voltage output from the output terminal OUT as an enable signal to control the reset or non-reset operation of each IC.

The reset circuit 700 receives the input voltage Vdd applied to the ICs. The reset circuit 700 generates the first control signal (disable) to cause the ICs to be not driven in the first period, in which the input voltage Vdd is less than the preset voltage as determined by the comparator in the reset circuit 700, and applies the first control signal to the buffers 310, 410, and 510 coupled to the respective ICs. The reset circuit 700 also generates the second control signal (enable) to cause the ICs to be driven in the second period, in which the input voltage Vdd is equal to the preset voltage or more, and applies the second control signal to the buffers 310, 410, and 510 coupled to the respective ICs.

Hereinafter, an exemplary operation of the reset circuit 700 according to the embodiment of the present invention will be described with reference to FIG. 2 and FIG. 3.

For the convenience of description, we will describe under the assumption that an operation voltage Vcc of the ICs is 5V and the preset voltage is 3.9V.

When the operation voltage Vcc is applied to the ICs, the ICs can operate normally. The operation voltage Vcc is provided by the input voltage Vdd from the power supply unit 600. However, the input voltage Vdd cannot reach the operation voltage Vcc at 5V instantaneously. In fact, there are a voltage rising period and a voltage falling period respectively corresponding to a period when power is first applied and a period when power is last applied from the power supply unit 600 in a typical power on/off cycle.

Thus, when the ICs are operated in the rising voltage period or the falling voltage period, the ICs may have a risk of malfunction as described above. Accordingly, in order to overcome the problem, the embodiment of the present invention allows the ICs to operate only when the input voltage Vdd is above at least the preset voltage.

Referring to FIG. 3, the input voltage Vdd rises during a rising voltage period, falls during a falling voltage period, and maintains or substantially maintains its voltage level during a maintaining period, as described above.

Also, the voltage input to the first input terminal V- increases or decreases with the input voltage Vdd corresponding to the equation (R2/(R1+R2))*Vdd. In one embodiment, the resistors R1 and R2 are selected such that the voltage at the input voltage V- reaches a desired voltage when the input voltage Vdd reaches the preset voltage (e.g., 3.9V).

In addition, the voltage input to the second input terminal V+ differs from the input voltage Vdd by the breakdown voltage Vz of the Zener diode ZD, so that the voltage input to the second input terminal V+ corresponds to the difference Vdd-Vz, wherein Vdd is the input voltage, and Vz is the breakdown voltage of the Zener diode ZD.

When each of the first input terminal V- and the second input terminal V+ of the comparator 702 is supplied with the respective voltage input, the comparator 702 compares the magnitudes of the voltages at the first and second input terminals, and outputs a low level signal or a high level signal.

When the voltage input to the first input terminal V- is larger than the voltage input to the second input terminal V+, the low level signal is output from the comparator 702, and when the voltage input to the second input terminal V+ is larger than the voltage input to the first input terminal V-, the high level signal is output from the comparator 702.

As shown in FIG. 3, when the voltage input to the second input terminal V+ is larger than the voltage input to the first input terminal V- in a period in which the input voltage Vdd is equal to or more than the preset voltage (e.g. 3.9V), the high level signal is output from the comparator 702, and when the voltage input to the first input terminal V- is larger than the voltage input to the second input terminal V+ in the remaining period, the low level signal is output from the comparator 702.

The low level signal is output by the comparator 702 in the period in which the input voltage Vdd is less than the preset voltage, and the high level signal is output by the comparator 702 in the period in which the input voltage Vdd is at the preset voltage or more.

When the output of the comparator is a low level signal, the transistor T1 is turned on to output the input voltage Vdd applied to the first node N1 coupled to the emitter of the transistor T 1 to the output terminal OUT coupled to the collector of the transistor T1.

Referring to FIGs. 2 and 3, the input voltage Vdd is output from the output terminal OUT of the reset circuit 700 during the period in which the output of the comparator 702 is the low level signal during the period in which the input voltage Vdd is less than the preset voltage. This serves as the first control signal (disable) to cause the ICs to not be driven.

When the output of the comparator 702 is a high level signal, the transistor T 1 is turned off to output a low level voltage corresponding to a ground voltage to the output terminal OUT coupled to the collector of the transistor.

Referring to FIGs. 2 and 3, the low level voltage is output from the output terminal OUT of the reset circuit 700 in the period where the output of the comparator 702 is the high level signal during the period in which the input voltage Vdd is at the preset voltage or more. This serves as the second control signal (enable) to cause the ICs to be driven.

The reset circuit 700 monitors the input voltage Vdd applied to the ICs from the power supply unit 600. The reset circuit 700 generates the first control signal (disable) to cause the ICs to not be driven during the period in which the input voltage Vdd is less than the preset voltage as determined by the comparator 702 and applies the first control signal to the buffers coupled to the respective ICs. The reset circuit 700 also generates the second control signal (enable) to cause the ICs to be driven during the period in which the input voltage Vdd is at the preset voltage or more and applies the second control signal to the buffers coupled to the respective ICs.

As a result, the malfunction of the ICs caused by the unstable states of the input signal and the input voltage applied to the ICs and the breakage of the ICs due to the malfunction can be prevented or reduced, making it possible to reduce the error rate of the plasma display device and to enhance the reliability and manufacturing yield of the plasma display device.

## Claims

1. A reset circuit for a plasma display device, wherein
the reset circuit is adapted to sense an input voltage; and
the reset circuit is adapted to output a control signal.

2. The reset circuit as claimed in claim 1, wherein the reset circuit comprises:
a comparator having a first input terminal and a second input terminal;
a Zener diode coupled between a first node for receiving the input voltage and the second input terminal; and
a transistor coupled between the first node and an output terminal of the reset circuit for receiving an output of the comparator,
wherein the first input terminal is adapted to receive a first terminal voltage that is less than the input voltage, and the second input terminal is adapted to receive a second terminal voltage corresponding to a difference Vdd-Vz, wherein Vdd is a voltage level of the input voltage, and Vz is a breakdown voltage of the Zener diode.

3. The reset circuit as claimed in claim 2, further comprising: a first resistor coupled between the first input terminal and the first node; and a second resistor coupled between the first input terminal and a ground.

4. The reset circuit as claimed in claim 3, wherein the first terminal voltage corresponds to (R2/(R1+R2))*Vdd generated by voltage-dividing the input voltage, wherein Vdd is the voltage level of the input voltage, R1 is the resistance of the first resistor, and R2 is the resistance of the second resistor.

5. The reset circuit as claimed in one of claims 2 to 4, wherein the second terminal voltage is adapted to differ from the input voltage by the breakdown voltage Vz of the Zener diode.

6. The reset circuit as claimed in one of claims 2 to 5, wherein the comparator is adapted to compare the magnitude of the first terminal voltage with the magnitude of the second terminal voltage, wherein the comparator is adapted to output a low level signal when the magnitude of the first terminal voltage is larger than that of the second terminal voltage and to output a high level signal when the magnitude of the second terminal voltage is larger than that of the first terminal voltage.

7. The reset circuit as claimed in one of claims 2 to 6, wherein the transistor is adapted to be turned on or turned off as determined by the output of the comparator to output the input voltage as a first control signal or to output a low level signal as a second control signal to the output terminal.

8. The reset circuit as claimed in claim 7, wherein the first control signal is output in a first period, in which the input voltage is less than a preset voltage, and the second control signal is output in a second period, in which the input voltage is at the preset voltage or higher.

9. A plasma display device comprising:
a plasma display panel comprising a plurality of address electrodes extending in a column direction, and a plurality of scan electrodes and a plurality of sustain electrodes extending in a row direction;
an address electrode driver for applying display data signals to the address electrodes to select a plurality of discharge cells to be displayed on the plasma display panel;
a sustain electrode driver and a scan electrode driver for applying driving voltages to the sustain electrodes and the scan electrodes, respectively;
a controller for receiving an image signal from an external source and for outputting an address electrode driving control signal, a sustain electrode driving control signal, and a scan electrode driving control signal;
a power supply unit for providing an input voltage to the address electrode driver, the scan electrode driver, and the sustain electrode driver; and
a reset circuit according to any one of the preceding claims for sensing the input voltage and for outputting a reset control signal to control a reset or non-reset of the address electrode driver, the scan electrode driver, and the sustain electrode driver.

10. The plasma display device as claimed in claim 9, wherein the address electrode driver, the sustain electrode driver, and the scan electrode driver are implemented by one or more integrated circuits (ICs).

11. The plasma display device as claimed in claim 9 or 10, further comprising a first buffer, a second buffer, and a third buffer for coupling the control signals from the controller and the reset circuit to the address electrode driver, the sustain electrode driver, and the scan electrode driver, respectively.

12. The plasma display device as claimed in one of claims 9 to 11 comprising a reset circuit as claimed in claim 8, wherein the drivers are adapted to not be driven during the first period, and the drivers are adapted to be driven in the second period.

13. The plasma display device as claimed in claims 11 and 12, wherein the first and second control signals are transmitted to the first, second, and third buffers coupled to the respective drivers.

14. A method for operating a driver of a plasma display device, wherein the driver receives an input voltage from an outside source, the method comprising:
monitoring the input voltage as received by the driver;
comparing the input voltage with a threshold voltage;
generating a first control signal to control the driver to be not driven when the input voltage is less than the threshold voltage; and
generating a second control signal to control the driver to be driven when the input voltage is equal to or higher than the threshold voltage,
wherein the threshold voltage is suitably selected to cause the driver to be not driven in order to prevent the driver from operating undesirably when the input voltage drops below the threshold voltage.

15. The method as claimed in claim 14, wherein the input voltage is an input power voltage applied to the driver.

16. The method as claimed in claim 14 or 15, wherein the threshold voltage is generated by using a breakdown voltage of a Zener diode.

17. The method as claimed in one of claims 14 to 16, wherein the comparing the input voltage to the threshold voltage utilizes a comparator circuit.

18. The method as claimed in one of claims 14 to 17, wherein the input voltage is voltage-divided before the input voltage is compared to the threshold voltage.
